# EUROPEAN PATENT APPLICATION

(11) **EP 3 287 551 A1**
(43) Date of publication of application: **28.02.2018**
(21) Application number: 16783254.2
(22) Date of filing: 22.04.2016
(51) Int. Cl.: D01F 1/10, D01D 5/04, D01F 6/50, G03F 7/022, G03F 7/038, G03F 7/039

(54) **PHOTOSENSITIVE FIBERS AND METHOD FOR FORMING FIBER PATTERN**

(30) Priority: 22.04.2015 JP 2015087963
(71) Applicant: Nissan Chemical Industries, Ltd., Chiyoda-ku Tokyo 101-0054 (JP); Toyama Prefecture, Toyama 930-8501 (JP)
(72) Inventor: KISHIOKA, Takahiro, Toyama-shi Toyama 939-2753 (JP); YOKOYAMA, Yoshiyuki, Toyama-shi Toyama 933-0866 (JP)
(74) Representative: J A Kemp
(86) International application number: PCT/JP2016/062704
(87) International publication number: WO 2016/171233

(57) **Abstract**

An object of the present invention is to provide a method capable of conveniently producing an intricate and fine resist pattern.

The present invention relates to a fiber containing a positive-type or negative-type photosensitive material.

## Description

### [Technical Field]

The present invention relates to a positive-type or negative-type photosensitive fiber and a production method thereof, a fiber pattern using the photosensitive fiber and a production method thereof, and a substrate having the fiber pattern on the surface.

### [Background Art]

In the production of semiconductor element and the like, fine processing by photolithography using resist has conventionally been performed. Such fine processing is a processing method for forming fine concaves/convexes corresponding to a resist pattern on a substrate surface, in which a resist film is formed on the substrate to be processed, after which a resist pattern is formed by exposing the film through a photomask and developing the film, and the substrate is etched by using the obtained resist pattern as an etching mask.

In recent years, more intricate and highly precise fine processing is required as the degree of integration of semiconductor elements becomes higher. Production of a resist pattern for practicing such fine processing problematically requires a photomask with an intricate and fine pattern drawn thereon and the like.

Conventionally, an ultrafine fiber having a diameter of a nano meter order has been attracting attention, and is expected to be utilizable in various fields of battery • information, environment • energy, medical care • welfare. Particularly, in the medical or research field using cells and the like, for example, utilization of a nanofiber (nano fiber) or a non-woven fabric thereof as a substrate to be a scaffold for cells has been proposed. Patent document 1 proposes substrates having fiber patterns of nano fiber formed on the surface by a stamp method using a stamp with a given pattern, a stencil method using a template (stencil) having a hole with a given pattern, a spray method for forming a given pattern by using spray and the like. For utilization as a culture substrate and the like for three-dimensional culture and two-layer culture system of cells, patent document 2 proposes a non-woven fabric of nano • micro fiber having minute concave-convex patterns, formed at given positions of a flat plane by using a template having given concaves and convexes, as a substrate for collecting a produced fiber (nano • micro fiber) (collector part), which is a part of an electrospinning apparatus. Patent document 3 proposes production of a temperature responsive fiber having a diameter of a few dozen nano-meter to a few hundred micro-meter, from a polymer solution of a temperature responsive polymer showing varying water-solubility depending on temperature, by dissolving the aforementioned temperature responsive polymer in a solvent and according to a method such as an electrospinning method or a wet method, and a non-woven fabric using same. Also, non-patent document 1 describes production of a nanofiber by introducing a UV crosslinking agent into a given stimuli-responsive polymer, and according to an electrospinning method, and production of a nanofiber mat for capturing or releasing cells, by crosslinking the nanofiber.

To subject an ultrafine fiber to the above-mentioned use, formation of a more intricate and fine fiber pattern is necessary. Particularly, it has not been realized in conventional ultrafine fibers (nano • micro fiber) to produce a fiber pattern by using a fiber having photosensitivity and directly processing the fiber according to a lithography method.

### [Document List]

### [Patent documents]

patent document 1: JP-A-2007-44149
patent document 2: JP-A-2006-328562
patent document 3: JP-A-2009-57522

### [non-patent document]

non-patent document 1: The 40th Medical Polymer Symposium proceeding p53-54, 2011

### [SUMMARY OF THE INVENTION]

### [Problems to be Solved by the Invention]

The present invention has been made in view of the above-mentioned situation, and the problem to be solved thereby is provision of a method capable of conveniently producing an intricate and fine resist pattern.

### [Means of Solving the Problems]

The present inventors have conducted intensive studies in an attempt to solve the aforementioned problems and found that an intricate and fine resist pattern (fiber pattern) can be conveniently produced by spinning (preferably, electrospinning) a starting material composition containing at least a positive-type or negative-type photosensitive material to give a photosensitive fiber, forming a fiber layer using said fiber, exposing the layer to light and developing same, which resulted in the completion of the present invention.

Accordingly, the present invention provides the following.

[1] A fiber comprising a positive-type or negative-type photosensitive material.
[2] The fiber of [1], wherein the positive-type photosensitive material comprises (i) a novolac resin and a dissolution inhibitor, (ii) a polyvinylphenol resin or acrylic resin, and a photoacid generator, or (iii) a polyvinylphenol resin or acrylic resin comprising a structural unit having a photoacid generating group in a side chain.
[3] The fiber of [1] or [2], wherein the negative-type photosensitive material comprises (A) a polymer compound comprising a structural unit having, in a side chain, at least one kind of organic group selected from a hydroxy group, a hydroxymethyl group and an alkoxymethyl group having 1 - 5 carbon atoms, and (B) a photoacid generator.
[4] The fiber of any one of [1] - [3], which is a photosensitive fiber.
[5] The fiber of any one of [1] - [4], comprising a nano fiber and/or a micro fiber.
[6] A composition for producing a photosensitive fiber, comprising a positive-type or negative-type photosensitive material, and a solvent.
[7] The composition of [6], wherein the positive-type photosensitive material comprises (i) a novolac resin and a dissolution inhibitor, (ii) a polyvinylphenol resin or acrylic resin, and a photoacid generator, or (iii) a polyvinylphenol resin or acrylic resin comprising a structural unit having a photoacid generating group in a side chain.
[8] The composition of [6] or [7], wherein the negative-type photosensitive material comprises (A) a polymer compound comprising a structural unit having, in a side chain, at least one kind of organic group selected from a hydroxy group, a hydroxymethyl group and an alkoxymethyl group having 1 - 5 carbon atoms, and (B) a photoacid generator.
[9] A production method of a photosensitive fiber, comprising a step of spinning the composition of any one of [6] - [8].
[10] The method of [9], wherein the above-mentioned spinning is electrospinning.
[11] The method of [9] or [10], comprising a step of heating a spun fiber at 70 - 300°C.
[12] A method of forming a fiber pattern, comprising
   the first step for forming a fiber layer of photosensitive fibers on a substrate,
   the second step for exposing the fiber layer to light via a mask, and
   the third step for developing the fiber layer with a developing solution.
[13] The method of [12], wherein the above-mentioned photosensitive fiber is the fiber of any one of [1] - [5].
[14] The method of [12] or [13], wherein the second step comprises heating the fiber after light exposure.
[15] The method of any one of [12] - [14], wherein the above-mentioned developer solution comprises water or an organic solvent.
[16] A fiber pattern formed using the fiber of any one of [1] - [5].
[17] A substrate having the fiber pattern of [16] on a surface.
[18] A method of producing a fiber pattern, comprising
   the first step for forming a fiber layer of photosensitive fibers on a substrate,
   the second step for exposing the fiber layer to light via a mask, and
   the third step for developing the fiber layer with a developing solution.
[19] The method of [18], wherein the above-mentioned photosensitive fiber is the fiber of any one of [1] - [5].
[20] The method of [18] or [19], wherein the second step comprises heating the fiber after light exposure.
[21] The method of any one of [18] - [20], wherein the above-mentioned developing solution comprises water or an organic solvent.
[22] A method of producing a substrate with a fiber pattern, comprising
   the first step for forming a fiber layer of photosensitive fibers on a substrate,
   the second step for exposing the fiber layer to light via a mask, and
   the third step for developing the fiber layer with a developing solution.
[23] The method of [22], wherein the above-mentioned photosensitive fiber is the fiber of any one of [1] - [5].
[24] The method of [22] or [23], wherein the second step comprises heating the fiber after light exposure.
[25] The method of any one of [22] - [24], wherein the above-mentioned developing solution comprises water or an organic solvent.

### [Effect of the Invention]

According to the present invention, a photosensitive fiber capable of conveniently producing an intricate and fine resist pattern and a fiber pattern formed using the photosensitive fiber, and a production method thereof can be provided.

According to the present invention, a composition for producing the above-mentioned photosensitive fiber (composition for producing a photosensitive fiber) can be provided.

According to the present invention, moreover, a substrate having the above-mentioned fiber pattern can be provided.

### [Brief Description of the Drawings]

Fig. 1 is an SEM photograph of a fiber layer (after electrospinning (before patterning)) of fibers obtained from the composition for producing a negative-type photosensitive fiber of Example 1.
Fig. 2 is an SEM photograph of a fiber pattern formed using fibers obtained from the composition for producing a negative-type photosensitive fiber of Example 1.
Fig. 3 is an SEM photograph (partly enlarged section) of a fiber pattern formed using fibers obtained from the composition for producing a negative-type photosensitive fiber of Example 1.
Fig. 4 is an SEM photograph (partly enlarged fiber part of Fig. 3) of a fiber pattern formed using fibers obtained from the composition for producing a negative-type photosensitive fiber of Example 1.
Fig. 5 is an optical microscopic photograph, before oven heating, of a fiber layer of fibers obtained from the composition for producing a positive-type photosensitive fiber of Example 2.
Fig. 6 is an optical microscopic photograph, after oven heating, of a fiber layer of fibers obtained from the composition for producing a positive-type photosensitive fiber of Example 2.
Fig. 7 is an SEM photograph, before light exposure, of a fiber layer of fibers obtained from the composition for producing a positive-type photosensitive fiber of Example 2.
Fig. 8 is an SEM photograph of a fiber pattern formed using fibers obtained from the composition for producing a positive-type photosensitive fiber of Example 2.
Fig. 9 is an optical microscopic photograph of a fiber obtained from the composition for producing a negative-type photosensitive fiber of Example 1 and after immersing in water at 20°C for 10 min.
Fig. 10 is an optical microscopic photograph of a fiber obtained from the composition for producing a negative-type photosensitive fiber of Example 1 and after immersing in water at 40°C for 10 min.

### [Description of Embodiments]

### 1. fiber and production method thereof

The fiber of the present invention is mainly characterized in that it contains a positive-type or negative-type photosensitive material.

That is, the fiber of the present invention is preferably a fiber obtained by spinning (more preferably electrospinning) a starting material composition containing at least a positive-type or negative-type photosensitive material.

In the present invention, a fiber containing a positive-type photosensitive material is referred to as a "positive-type photosensitive fiber", and a fiber containing a negative-type photosensitive material is sometimes to be referred to as a "negative-type photosensitive fiber".

Since the diameter of the fiber of the present invention can be appropriately adjusted according to the use of the fiber and the like, it is not particularly limited. However, from the aspects of application to an etching mask in processing various substrates used for display or semiconductor, medical material, cosmetic material, and the like, the fiber of the present invention is preferably a fiber having a diameter of a nano meter order (e.g., 1 - 1000 nm) (nano fiber) and/or a micro meter order (e.g., 1 - 1000 µm) (micro fiber). In the present invention, the diameter of a fiber is measured by a scanning electron microscope (SEM).

In the present invention, a "positive-type photosensitive material" refers to a material that easily becomes alkali-soluble from poorly alkali-soluble or alkali-insoluble (e.g., positive-type photoresist, positive-type photosensitive resin composition etc.) due to the action of light, and a "negative-type photosensitive material" refers to a material that easily becomes poorly alkali-soluble or alkali-insoluble from easily alkali-soluble (e.g., negative-type photoresist, negative-type photosensitive resin composition etc.) due to the action of light.

The positive-type photosensitive material is not particularly limited as long as it can be formed into a fiber, and a known material conventionally used as a positive-type photoresist, a positive-type photosensitive resin composition or the like can be used, with preference given to a chemically amplified positive-type photosensitive material. Examples of the chemically amplified positive-type photosensitive material include (i) a novolac resin and a dissolution inhibitor; (ii) a polyvinylphenol resin or an acrylic resin and a photoacid generator; (iii) a polyvinylphenol resin or an acrylic resin comprising a structural unit having a photoacid generating group in a side chain; and the like. Of these, (i) a novolac resin and a dissolution inhibitor are preferable.

The positive-type photosensitive material to be used in the present invention may contain the above-mentioned (i), or the above-mentioned (ii), or the above-mentioned (iii).

As the novolac resin, those conventionally used as positive-type photosensitive materials can be used without limitation. Examples thereof include resins obtained by polymerizing phenols and aldehydes in the presence of an acid catalyst and the like.

Examples of the above-mentioned phenols include cresols such as phenol, o-cresol, m-cresol, p-cresol and the like; xylenols such as 2,3-xylenol, 2,4-xylenol, 2,5-xylenol, 2,6-xylenol, 3,4-xylenol, 3,5-xylenol and the like; alkylphenols such as o-ethylphenol, m-ethylphenol, p-ethylphenol, 2-isopropylphenol, 3-isopropylphenol, 4-isopropylphenol, o-butylphenol, m-butylphenol, p-butylphenol, p-tert-butylphenol and the like; trialkylphenols such as 2,3,5-trimethylphenol, 3,4,5-trimethylphenol and the like; polyphenols such as resorcinol, catechol, hydroquinone, hydroquinone monomethyl ether, pyrogallol, phloroglucinol and the like; alkyl polyphenols such as alkyl resorcin, alkyl catechol, alkyl hydroquinone and the like (all alkyl groups have carbon number 1 - 4); α-naphthol, β-naphthol, hydroxydiphenyl, bisphenol A and the like. These phenols may be used singly, or two or more kinds thereof may be used in combination.

Examples of the above-mentioned aldehydes include formaldehyde, para-formaldehyde, furfural, benzaldehyde, nitrobenzaldehyde, acetaldehyde and the like. These aldehydes may be used singly, or two or more kinds thereof may be used in combination.

Examples of the above-mentioned acid catalyst include inorganic acids such as hydrochloric acid, sulfuric acid, nitric acid, phosphoric acid, phosphorous acid and the like; organic acids such as formic acid, oxalic acid, acetic acid, diethylsulfuric acid, p-toluenesulfonic acid and the like; metal salts such as zinc acetate and the like, and the like.

While the weight average molecular weight of the novolac resin is not particularly limited, it is preferably 500 - 50,000 and, from the aspects of resolution and spinnability, more preferably 1,500 - 15,000.

In the present invention, the "weight average molecular weight" means a molecular weight based on polystyrene as measured by gel permeation chromatography (GPC).

As the dissolution inhibitor, those conventionally used as a photosensitizer in a positive-type photosensitive material can be used without limitation. Examples thereof include naphthoquinone diazide compounds such as 1,2-naphthoquinonediazo-5-sulfonic acid ester, 1,2-naphthoquinonediazo-4-sulfonic acid ester and the like, and the like, with preference given to 1,2-naphthoquinonediazo-5-sulfonic acid ester.

The content of the dissolution inhibitor is generally 5 - 50 parts by weight, preferably 10 - 40 parts by weight, per 100 parts by weight of the novolac resin.

As the polyvinylphenol resin, those conventionally used as a positive-type photosensitive material can be used without limitation. Examples thereof include resins obtained by polymerizing hydroxystyrenes in the presence of a radical polymerization initiator and the like.

Examples of the above-mentioned hydroxystyrenes include o-hydroxystyrene, m-hydroxystyrene, p-hydroxystyrene, 2-(o-hydroxyphenyl)propylene, 2-(m-hydroxyphenyl)propylene, 2-(p-hydroxyphenyl)propylene and the like. These hydroxystyrenes may be used singly, or two or more kinds thereof may be used in combination.

Examples of the above-mentioned radical polymerization initiator include organic peroxides such as benzoyl peroxide, dicumyl peroxide, dibutyl peroxide and the like; azobis compounds such as azobisisobutyronitrile, azobisvaleronitrile and the like, and the like.

While the weight average molecular weight of the polyvinylphenol resin is not particularly limited, it is preferably 500 - 50,000 and, from the aspects of resolution and spinnability, more preferably 1,500 - 25,000.

As the acrylic resin, those conventionally used for positive-type photosensitive material can be used without limitation. Examples thereof include resins obtained by polymerizing polymerizable monomers having a (meth)acrylic group in the presence of a radical polymerization initiator and the like.

Examples of the above-mentioned polymerizable monomers having a (meth)acrylic group include (meth)alkyl acrylates such as methyl (meth)acrylate, ethyl (meth)acrylate, propyl (meth)acrylate, butyl (meth)acrylate, pentyl (meth)acrylate, hexyl (meth)acrylate, heptyl (meth)acrylate, octyl (meth)acrylate, 2-ethylhexyl (meth)acrylate, nonyl (meth)acrylate, decyl (meth)acrylate, undecyl (meth)acrylate, dodecyl (meth)acrylate, trifluoroethyl (meth)acrylate, and tetrafluoropropyl (meth)acrylate and the like; acrylamides such as diacetone acrylamide and the like; tetrahydrofurfuryl (meth)acrylate, dialkylaminoethyl (meth)acrylate, glycidyl (meth)acrylate, (meth)acrylic acid, α-bromo (meth)acrylic acid, α-chloro (meth)acrylic acid, β-furyl (meth)acrylic acid, and β-styryl (meth)acrylic acid and the like. These polymerizable monomers having a (meth)acrylic group may be used singly, or two or more kinds thereof may be used in combination.

Examples of the above-mentioned radical polymerization initiator include organic peroxides such as benzoyl peroxide, dicumyl peroxide, dibutyl peroxide and the like; azobis compounds such as azobisisobutyronitrile, azobisvaleronitrile and the like, and the like.

Moreover, the above-mentioned acrylic resin may be copolymerized with, in addition to the polymerizable monomer having a (meth)acrylic group, one or more kinds of polymerizable monomers such as styrene, polymerizable styrene derivatives substituted at the α-position or aromatic ring, such as vinyltoluene, α-methylstyrene and the like; acrylonitrile, vinyl alcohol esters such as vinyl-n-butyl ether and the like; maleic acid, maleic anhydride, maleic acid mono esters such as monomethyl maleate, monoethyl maleate, monoisopropyl maleate and the like; fumaric acid, cinnamic acid, α-cyanocinnamic acid, itaconic acid, crotonic acid and the like.

In the present specification, "(meth)acrylic" means both "acrylic" and "methacryl".

While the weight average molecular weight of the acrylic resin is not particularly limited, it is preferably 500 - 50,000 and, from the aspects of resolution and spinnability, more preferably 1,500 - 100,000.

The polyvinylphenol resin or acrylic resin preferably has a structural unit having an alkali-soluble group protected by an acid-labile protecting group in a side chain.

Examples of the above-mentioned acid-labile protecting group include tert-butyl group, tert-butoxycarbonyl group, tert-butoxycarbonylmethyl group, tert-amyloxycarbonyl group, tert-amyloxycarbonylmethyl group, 1,1-diethylpropyloxycarbonyl group, 1,1-diethylpropyloxycarbonylmethyl group, 1-ethylcyclopentyloxycarbonyl group, 1-ethylcyclopentyloxycarbonylmethyl group, 1-ethyl-2-cyclopentenyloxycarbonyl group, 1-ethyl-2-cyclopentenyloxycarbonylmethyl group, 1-ethoxyethoxycarbonylmethyl group, 2-tetrahydropyranyloxycarbonylmethyl group, 2-tetrahydrofuranyloxycarbonylmethyl group, tetrahydrofuran-2-yl group, 2-methyltetrahydrofuran-2-yl group, tetrahydropyran-2-yl group, 2-methyltetrahydropyran-2-yl group and the like.

Examples of the above-mentioned alkali-soluble group include phenolic hydroxy group, carboxy group and the like.

A polyvinylphenol resin or acrylic resin containing a structural unit having an alkali-soluble group protected by an acid-labile protecting group in a side chain can be produced by, for example, introducing an acid-labile protecting group by a chemical reaction with an alkali-soluble group of a polyvinylphenol resin or acrylic resin. In addition, it can also be produced by mixing a starting material monomer of a polyvinylphenol resin or acrylic resin with a monomer corresponding to a structural unit having an alkali-soluble group, which is protected by an acid-labile protecting group, in a side chain, and copolymerizing the obtained monomer mixture.

The photoacid generator is not particularly limited as long as it is a compound that directly or indirectly develops an acid by the action of light and, for example, diazomethane compound, onium salt compound, sulfonimide compound, nitrobenzyl compound, iron arene complex, benzoin tosylate compound, halogen-containing triazine compound, a cyano group-containing oxime sulfonate compound and naphthalimide compound and the like can be mentioned.

The content of the photoacid generator is generally 0.1 - 50 parts by weight, preferably 3 - 30 parts by weight, per 100 parts by weight, polyvinylphenol resin or acrylic resin.

The polyvinylphenol resin or acrylic resin comprising a structural unit having a photoacid generating group in a side chain can be produced by, for example, mixing a starting material monomer of a polyvinylphenol resin or acrylic resin with the above-mentioned photoacid generator as a monomer, and copolymerizing the obtained monomer mixture.

While the weight average molecular weight of the polyvinylphenol resin comprising a structural unit having a photoacid generating group in a side chain is not particularly limited, it is preferably 500 - 50,000 and, from the aspects of resolution and spinnability, more preferably 1,500 - 25,000.

While the weight average molecular weight of the acrylic resin comprising a structural unit having a photoacid generating group in a side chain is not particularly limited, it is preferably 500 - 500,000 and, from the aspects of resolution and spinnability, more preferably 1,500 - 10,000.

The positive-type photosensitive material may be produced by a method known per se, and, for example, (i) a positive-type photosensitive material (positive-type photoresist) containing a novolac resin and a dissolution inhibitor can be produced by the method described in JP-B-7-66184 or the like, (ii) a positive-type photosensitive material (positive-type photoresist) containing a polyvinylphenol resin or acrylic resin and a photoacid generator can be produced by the method described in JP-B-7-66184, JP-A-2007-79589, JP-A-10-207066 or the like, and (iii) a positive-type photosensitive material (positive-type photoresist) containing a polyvinylphenol resin or acrylic resin comprising a structural unit having a photoacid generating group in a side chain can be produced by the method described in JP-A-9-189998, JP-A-2002-72483, JP-A-2010-85971, JP-A-2010-256856 or the like.

As the positive-type photosensitive material, a commercially available product may be used.

The negative-type photosensitive material to be used in the present invention is not particularly limited as long as it can form a fiber, and known materials conventionally used as negative-type photoresist, negative-type photosensitive resin composition or the like may be used, with preference given to a chemically amplified negative-type photosensitive material. Examples of the chemically amplified negative-type photosensitive material include (A) a polymer compound comprising a structural unit having, in a side chain, at least one kind of organic group selected from a hydroxy group, a hydroxymethyl group and an alkoxymethyl group having 1 - 5 carbon atoms (preferably, polymer compound capable of forming a crosslinked structure by using an acid as a catalyst) and (B) a photoacid generator and the like.

The negative-type photosensitive material to be used in the present invention may containing (A) a polymer compound comprising a structural unit having, in a side chain, at least one kind of organic group selected from a hydroxy group, a hydroxymethyl group and an alkoxymethyl group having 1 - 5 carbon atoms (hereinafter to be also simply referred to as "component A") and (B) a photoacid generator.

### [Component A]

Component A comprises a structural unit having, in a side chain, at least one kind of organic group selected from a hydroxy group, a hydroxymethyl group and an alkoxymethyl group having 1 - 5 carbon atoms. It is reacted with at least one kind of organic group selected from a hydroxy group, a hydroxymethyl group and an alkoxymethyl group having 1 - 5 carbon atoms, using an acid (H⁺) developed from a photoacid generator as a catalyst, whereby polymer chains are bonded to form a crosslinked structure.

Of such organic groups, a hydroxy group is particularly preferable in view of reactivity.

As used herein, the "alkoxymethyl group having 1 - 5 carbon atoms" may be linear or branched chain, and concrete examples thereof include methoxymethyl group, ethoxymethyl group, n-propoxymethyl group, isopropoxymethyl group, n-butoxymethyl group, isobutoxymethyl group, sec-butoxymethyl group, tert-butoxymethyl group, n-pentoxymethyl group, isopentoxymethyl group, neopentoxymethyl group, tert-pentoxymethyl group, 1-ethylpropoxymethyl group, 2-methylbutoxymethyl group and the like. The alkoxymethyl group has a carbon atom number of preferably 1 - 4, more preferably 1 - 3.

Component A preferably comprises (A1) a polymer compound comprising a structural unit represented by the formula (1): 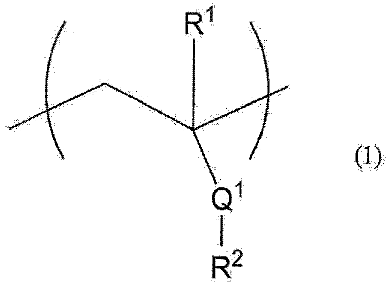 wherein
R¹ is a hydrogen atom or a methyl group,
Q¹ is an ester bond or an amide bond, and
R² is an alkyl group having 1 - 10 carbon atoms or an aromatic hydrocarbon group having 6 - 10 carbon atoms, wherein at least one hydrogen atom is substituted by a hydroxy group, a hydroxymethyl group or an alkoxymethyl group having 1 - 5 carbon atoms (hereinafter to be referred to simply as "component A1"), and/or (A2) a natural polymer (hereinafter to be also simply referred to as "component A2"). More preferably, component A is component A1 and/or component A2.

The definition of each group in the formula (1) is described in detail in the following.

R¹ is a hydrogen atom or a methyl group.

Q¹ is an ester bond or an amide bond.

R² is an alkyl group having 1 - 10 carbon atoms or an aromatic hydrocarbon group having 6 - 10 carbon atoms, wherein at least one hydrogen atom is substituted by a hydroxy group, a hydroxymethyl group or an alkoxymethyl group having 1 - 5 carbon atoms.

The "alkoxymethyl group having 1 - 5 carbon atoms" may be linear or branched chain, and concrete examples thereof include those similar to those mentioned above, and a preferable carbon atom number is also similar to that mentioned above.

The alkyl group having 1 - 10 carbon atoms may be linear or branched chain, and concrete examples thereof include methyl group, ethyl group, n-propyl group, isopropyl group, n-butyl group, isobutyl group, sec-butyl group, tert-butyl group, n-pentyl group, isopentyl group, neopentyl group, tert-pentyl group, 1-ethylpropyl group, n-hexyl group, isohexyl group, 1,1-dimethylbutyl group, 2,2-dimethylbutyl group, 3,3-dimethylbutyl group, 2-ethylbutyl group, hexyl group, pentyl group, octyl group, nonyl group, decyl group and the like. The number of the carbon atoms of the alkyl group is preferably 1 - 6, more preferably 1 - 4.

Examples of the aromatic hydrocarbon group having 6 - 10 carbon atoms for R² include phenyl group, 1-naphthyl group, 2-naphthyl group and the like.

Since R² is reacted as a reactive crosslinking reaction site when the fiber formed using a negative-type photosensitive material is exposed to light, by using component B as a catalyst, it is preferably an alkyl group having 1 - 10 (more preferably 1 - 6, particularly preferably 1 - 4) carbon atoms, wherein at least one hydrogen atom is substituted by a hydroxy group, a hydroxymethyl group or an alkoxymethyl group having 1 - 5 carbon atoms (more preferably a hydroxy group), or a phenyl group wherein at least one hydrogen atom is substituted by a hydroxy group, a hydroxymethyl group or an alkoxymethyl group having 1 - 5 carbon atoms (more preferably a hydroxy group).

In a preferable structural unit represented by the formula (1), R¹ is a hydrogen atom or a methyl group, Q¹ is an ester bond, R² is an alkyl group having 1 - 10 (more preferably 1 - 6, particularly preferably 1 - 4) carbon atoms, wherein at least one hydrogen atom is substituted by a hydroxy group.

The structural unit represented by the formula (1) is preferably a structural unit represented by the formula (1A). 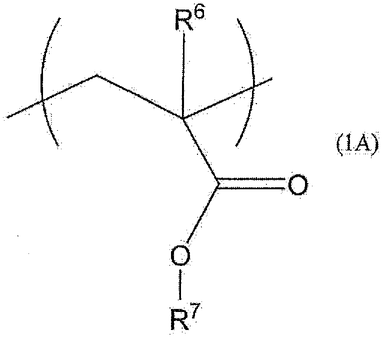 wherein R⁶ is as defined for the above-mentioned R¹, and R⁷ is as defined for the above-mentioned R².

The component A1 may contain one kind of the structural unit represented by the formula (1), or two or more kinds thereof.

While component A1 may contain a structural unit other than the structural unit represented by the formula (1) as long as the object of the present invention is not impaired, the content ratio of the structural unit represented by the formula (1) to the total structural unit of component A1 is preferably not less than 5 mol%, more preferably not less than 15 mol%, from the aspects of the efficiency of the crosslinking reaction.

Component A1 further desirably contains a structural unit represented by the formula (2): 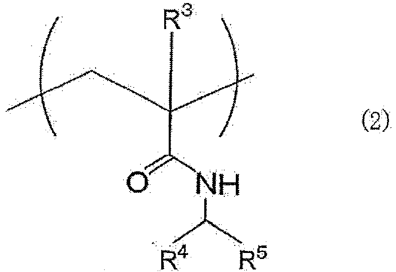 wherein
R³ is a hydrogen atom or a methyl group,
R⁴ and R⁵ may be the same or different and each is a hydrogen atom or an alkyl group having 1 - 4 carbon atoms, which is optionally substituted by a hydroxy group or a carboxy group.

Component A1 may contain one kind of the structural unit represented by the formula (2), or two or more kinds thereof.

The "alkyl group having 1 - 4 carbon atoms" for R⁴ or R⁵ in the formula (2) may be linear or branched chain. Concrete examples thereof include methyl group, ethyl group, n-propyl group, isopropyl group, n-butyl group, and isobutyl group.

In the present invention, being "optionally substituted by a hydroxy group or a carboxy group" means that a hydrogen atom contained in the above-mentioned "alkyl group having 1 - 4 carbon atoms" is optionally partly or entirely substituted by a hydroxy group or a carboxy group.

In the structural unit represented by the formula (2), R³ is a hydrogen atom or a methyl group, and R⁴ and R⁵ are more preferably methyl groups.

The weight average molecular weight of component A1 is preferably 1,000 - 1,000,000, more preferably 5,000 - 500,000, particularly preferably 10,000 - 200,000, from the aspects of appropriate fiber formation.

Component A1 may be used alone, or two or more kinds thereof may be used in combination.

Component A1 can be produced by a method known per se or a method analogous thereto. For example, it can be produced by polymerizing a monomer corresponding to each structural unit (a monomer corresponding to the structural unit represented by the formula (1), a structural unit other than the structural unit represented by the formula (1) (preferably a monomer corresponding to the structural unit represented by the formula (2)) in a suitable solvent (e.g., propylene glycol monoethyl ether etc.) by using a suitable polymerization initiator (e.g., 2,2'-azobisisobutyronitrile etc.), but the method is not limited thereto. In addition, a commercially available product can also be used.

Examples of the monomer corresponding to the structural unit represented by the formula (1) include 2-hydroxyethyl (meth)acrylate (e.g., compound of CAS number: 868-77-9), 2-hydroxypropyl (meth)acrylate (e.g., compound of CAS number: 923-26-2), 4-hydroxybutyl (meth)acrylate (e.g., compound of CAS number: 2478-10-6), N-hydroxymethyl (meth)acrylamide (e.g., compound of CAS number: 923-02-4), N-(2-hydroxyethyl) (meth)acrylamide (e.g., compound of CAS number: 5238-56-2), N-(2-hydroxypropyl) (meth)acrylamide (e.g., compound of CAS number: 26099-09-2), p-hydroxy (meth)acrylic anilide (e.g., compound of CAS number: 19243-95-9), N-methoxymethyl (meth)acrylamide, N-butoxymethyl (meth)acrylamide and the like. Preferred is 2-hydroxyethyl (meth)acrylate, 2-hydroxypropyl (meth)acrylate, N-methoxymethyl (meth)acrylamide, or N-butoxymethyl (meth)acrylamide, and most preferred is 2-hydroxyethyl (meth)acrylate. In the present invention, the (meth)acrylate compound refers to both an acrylate compound and a methacrylate compound.

Examples of the monomer corresponding to the structural unit represented by the formula (2) include N-isopropyl (meth)acrylamide, N-(1-methylpropyl) (meth)acrylamide, N-(1-ethylpropyl) (meth)acrylamide, N-(1-propylbutyl) (meth)acrylamide, N-(1-butylpentyl) (meth)acrylamide, 2-carboxyisopropyl (meth)acrylamide, 2-hydroxyisopropyl (meth)acrylamide and the like, and N-isopropyl (meth)acrylamide, 2-carboxyisopropyl (meth)acrylamide or 2-hydroxyisopropyl (meth)acrylamide is most preferable.

When component A1 has a structural unit represented by the formula (2), as shown in the below-mentioned Examples, the fiber of the present invention shows temperature responsiveness. In this case, the content ratio of the structural unit represented by the formula (2) to the total structural unit of component A1 is preferably 60 - 95 mol%. Since the fiber of the present invention shows temperature responsiveness, for example, a fiber pattern with varying sizes in response to the temperature can be formed. Such fiber and fiber pattern are advantageous in that application to, for example, (i) a drug delivery system (DDS) and a medicament sheet capable of keeping or releasing water, medicament and the like in or from the fiber, (ii) a filter and the like capable of controlling passage of substances by increasing or decreasing the fiber diameter, (iii) a device and the like capable of controlling attachment of substances by controlling hydrophobicity/hydrophilicity of the surface, and the like can be expected.

Component A1 may further contain, in addition to the structural unit represented by the formula (1) and the structural unit represented by the formula (2), an optional structural unit. Such optional structural unit is not particularly limited as long as it is a structural unit derived from a monomer, does not impair the property of the fiber of the present invention, and can polymerize with a monomer corresponding to the structural unit represented by the above-mentioned formula (1) and a monomer corresponding to the structural unit represented by the formula (2). Examples of such monomer include (meth)acrylates wherein the alkyl group has 1 - 10 carbon atoms, benzyl (meth)acrylate, acrylamides (e.g., acrylamide, N-alkylacrylamide, N-arylacrylamide, N,N-dialkylacrylamide, N,N-diarylacrylamide, N-methyl-N-phenylacrylamide, N-2-acetamidoethyl-N-acetylacrylamide etc.), methacrylamides (e.g., methacrylamide, N-alkylmethacrylamide, N-arylmethacrylamide, N,N-dialkylmethacrylamide, N,N-diarylmethacrylamide, N-methyl-N-phenylmethacrylamide, N-ethyl-N-phenylmethacrylamide etc.). Any one kind of these monomers may be used alone, or two or more kinds thereof may be used in combination.

When, for example, (meth)acrylates wherein the alkyl group has 1 - 10 carbon atoms, benzyl (meth)acrylate or the like, having a hydrophobic side chain, are used, the hydrophilicity-hydrophobicity balance of component A1 can be adjusted.

Component A2 is not particularly limited as long as it is a natural polymer containing a structural unit having, in a side chain, at least one kind of organic group selected from a hydroxy group, a hydroxymethyl group and an alkoxymethyl group having 1 - 5 carbon atoms (preferably, natural polymer capable of forming a crosslinked structure by using acid as a catalyst). Component A2 may be a denatured natural polymer obtained by a reaction such as hydrolysis and the like of a natural polymer. In addition, component A2 may be a biopolymer (including denatured biopolymer). In the present specification, the "biopolymer" is a generic term for polymers derived from living organisms.

Component A2 is preferably dextrin which is a hydrolysate of starch or glycogen, or a derivative thereof. Here, the dextrin derivative is a dextrin wherein a hydroxy group is partly or entirely substituted by a substituent (e.g., acetoxy group, benzoyl group etc.).

The weight average molecular weight of component A2 is preferably 1,000 - 5,000,000, more preferably 1,000 - 100,000.

Component A2 may be any one kind to be used alone, or two or more kinds thereof may be used in combination.

### [Component B]

The photoacid generator of component B is not particularly limited as long as it is a compound that directly or indirectly develops an acid by the action of light. Examples thereof include diazomethane compound, onium salt compound, sulfonimide compound, nitrobenzyl compound, iron arene complex, benzointosylate compound, halogen-containing triazine compound, oxime sulfonate compound containing a cyano group, naphthalimide compound, and the like.

Examples of the diazomethane compound include bis(p-toluenesulfonyl)diazomethane, bis(1,1-dimethylethylsulfonyl)diazomethane, bis(cyclohexylsulfonyl)diazomethane, bis(2,4-dimethylphenylsulfonyl)diazomethane and the like.

Examples of the onium salt compound include bis(4-tert-butylphenyl)iodonium trifluoromethanesulfonate, triphenylsulfonium trifluoromethanesulfonate and the like.

Examples of the sulfonimide compound include N-(trifluoromethanesulfonyloxy)succinimide, N-(nonafluoro-normal butanesulfonyloxy)succinimide, N-(camphorsulfonyloxy)succinimide, N-(trifluoromethanesulfonyloxy)naphthalimide and the like.

Examples of the nitrobenzyl compound include 2-nitrobenzyl p-toluenesulfonate, 2,6-dinitrobenzyl p-toluenesulfonate, 2,4-dinitrobenzyl p-toluenesulfonate and the like.

Examples of the iron arene complex include biscyclopentadienyl-(η⁶-isopropylbenzene)-iron(II) hexafluorophosphate and the like.

Examples of the benzointosylate compound include benzointosylate, α-methylbenzointosylate and the like.

Examples of the halogen-containing triazine compound include 2-(4-methoxyphenyl)-4,6-bis(trichloromethyl)-1,3,5-triazine, 2-(4-methoxynaphthyl)-4,6-bis(trichloromethyl)-1,3,5-triazine, 2-[2-(2-furyl)ethenyl]-4,6-bis(trichloromethyl)-1,3,5-triazine, 2-[2-(5-methyl-2-furyl)ethenyl]-4,6-bis(trichloromethyl)-1,3,5-triazine and the like.

Examples of the oxime sulfonate compound containing a cyano group include α-(methylsulfonyloxyimino)-4-methoxybenzyl cyanide, α-(trifluoromethylsulfonyloxyimino)-4-methoxybenzyl cyanide, α-(ethylsulfonyloxyimino)-4-methoxybenzyl cyanide, α-(propylsulfonyloxyimino)-4-methylbenzyl cyanide and the like.

Examples of the naphthalimide compound include 6-(n-butylthio)-2-(perfluorobutylsulfonyloxy)-2-aza-2H-phenalene-1,3-dione, 6-(n-butylthio)-2-(trifluoromethylsulfonyloxy)-2-aza-2H-phenalene-1,3-dione and 6-(isopropylthio)-2-(trifluoromethylsulfonyloxy)-2-aza-2H-phenalene-1,3-dione and the like.

Component B is preferably an oxime sulfonate compound containing a cyano group, and particularly preferably α-(methylsulfonyloxyimino)-4-methoxybenzyl cyanide.

Component B may be any one kind to be used alone, or two or more kinds thereof may be used in combination. Component B can be produced by a method known per se or a method analogous thereto. In addition, a commercially available product may also be used.

### [component C]

A negative-type photosensitive material containing component A and component B may further contain (C) a crosslinking agent (hereinafter to be also simply referred to as "component C").

As component C, any compound having, in one molecule, two or more organic groups capable of reacting with at least one kind of organic group possessed by component A, which is selected from a hydroxy group, a hydroxymethyl group and an alkoxymethyl group having 1 - 5 carbon atoms, by using an acid (H⁺) developed by component B as a catalyst can be used without any particular limitation. Preferred is a compound having 3 or 4 organic groups, more preferably 4 organic groups, in one molecule.

Specific examples thereof include aminoplast crosslinking agents such as 1,3,4,6-tetrakis(methoxymethyl)glycoluril, 1,3,4,6-tetrakis(butoxy methyl)glycoluril and the like; phenoplast crosslinking agents such as 2,2-bis(4-hydroxy-3,5-dihydroxymethylphenyl)propane and the like; isocyanate crosslinking agents such as hexamethylene diisocyanate and the like; vinylether crosslinking agents such as 1,4-bis(vinyloxy)butane and the like; and the like.

Component C is preferably an aminoplast crosslinking agent, which is preferably 1,3,4,6-tetrakis(methoxymethyl)glycoluril or 1,3,4,6-tetrakis(butoxymethyl)glycoluril, more preferably 1,3,4,6-tetrakis(methoxymethyl)glycoluril.

Component C may be any one kind to be used alone, or two or more kinds thereof may be used in combination. Component C can be produced by a method known per se or a method analogous thereto. In addition, a commercially available product may also be used.

Since the negative-type photosensitive material contains component C, when component B develops an acid (H⁺), not only a crosslinked structure resulting from a reaction of polymer chains of component A, but also a reaction of three-dimensional crosslinking of polymer chains of component A via component C proceed.

In the present invention, moreover, the negative-type photosensitive material may be a commercially available product.

The fiber of the present invention is preferably produced by spinning a composition for producing a photosensitive fiber, which contains a positive-type or negative-type photosensitive material and a solvent (hereinafter to be also simply referred to as "the composition of the present invention").

While the solvent is not particularly limited as long as it can uniformly dissolve or disperse positive-type or negative-type photosensitive material, and does not react with each material, a polar solvent is preferable.

Examples of the polar solvent include water, methanol, ethanol, 2-propanol, propylene glycol monomethyl ether, propylene glycol monomethyl ether acetate, acetone, dimethylformamide, dimethylacetamide, N-methylpyrrolidone and the like. Preferred for easy spinning of the composition for producing a photosensitive fiber is propylene glycol monomethyl ether or propylene glycol monomethyl ether acetate.

The solvent may be used singly, or two or more kinds thereof may be used in combination.

From the aspects of resolution and spinnability, the content of the positive-type or negative-type photosensitive material in the composition of the present invention is preferably 60 - 100 wt%, more preferably 60 - 95 wt%, particularly preferably 70 - 90 wt%, based on the solid content of the composition for photosensitive fiber production excluding the solvent.

When the composition of the present invention contains a negative-type photosensitive material containing components A and B, the content ratio of component A in the composition of the present invention is preferably 1 - 90 wt%, more preferably 5 - 70 wt%, from the aspects of the production of a fiber having an appropriate thickness, and the preservation stability of the composition of the present invention.

When the composition of the present invention contains a negative-type photosensitive material containing components A and B, the content ratio of component B in the composition of the present invention is preferably 0.1 - 50 wt%, more preferably 0.5 - 40 wt%, particularly preferably 1 - 20 wt%, to maintain the property of the temperature responsive resin and the resolution and spinnability.

When the composition of the present invention contains a negative-type photosensitive material containing components A and B, the weight ratio of component A and component B (weight of component A/weight of component B) in the composition of the present invention is preferably 5 - 50, more preferably 10 - 40, from the aspects of the reaction efficiency of component A and component B.

When the composition of the present invention contains a negative-type photosensitive material containing components A - C, the content ratio of component C in the composition of the present invention is preferably 0.1 - 15 wt%, more preferably 0.3 - 10 wt%, particularly preferably 0.5 - 5, from the aspects of the reaction efficiency with component A.

The composition of the present invention may contain, as necessary besides positive-type or negative-type photosensitive material, an additive generally used for a composition for fiber production as long as the object of the present invention is not markedly impaired. Examples of the additive include surfactant, rheology adjusting agent, chemical agent, fine particles and the like.

The composition of the present invention can be prepared by mixing positive-type or negative-type photosensitive material with a solvent, or the same and further the above-mentioned additive. The mixing method is not particularly limited, and a method known per se or a method analogous thereto can be used for mixing.

The spinning method of the composition of the present invention is not particularly limited as long as it can form a fiber. For example, melt blow method, composite melt spinning method, electrospinning method and the like can be mentioned, and electrospinning method is preferable from the aspect of the ultrafine fiber (nano fiber, micro fiber) forming ability.

Electrospinning method is a known spinning method, and can be performed using a known electrospinning apparatus. Various conditions such as the speed of discharge of the composition of the present invention from the tip of a nozzle (e.g., needle etc.) (discharge speed); application voltage; the distance between the tip of a nozzle discharging the composition of the present invention and a substrate for receiving same (discharge distance) and the like can be appropriately determined according to the diameter of the fiber to be produced and the like. The discharge speed is generally 0.1 - 100 µl/min, preferably 0.5 - 50 µl/min, more preferably 1 - 20 µl/min. The application voltage is generally 0.5 - 80 kV, preferably 1 - 60 kV, more preferably 3 - 40 kV. The discharge distance is generally 1 - 60 cm, preferably 2 - 40 cm, more preferably 3 - 30 cm.

The electrospinning method may be performed using a drum collector and the like. Using a drum collector and the like, the orientation of the fiber can be controlled. For example, when the drum is rotated at a low speed, a non-woven fabric and the like can be obtained, and when it is rotated at a high speed, an orientational fiber sheet and the like can be obtained. This is effective for producing an etching mask material and the like in processing semiconductor materials (e.g., substrate etc.).

The production method of the fiber of the present invention preferably further includes, in addition to the aforementioned spinning step, a step of heating the spun fiber at a particular temperature.

The temperature for heating a spun fiber is generally 70 - 300°C, preferably 80 - 250°C, more preferably 90 - 200°C. When the temperature is less than 70°C and, for example, when the composition of the present invention contains a negative-type photosensitive material containing components A and B, the crosslinking reaction of components A becomes insufficient, and the produced fiber tends to show lower resistance to organic solvents. When it exceeds 300°C and, for example, when the composition of the present invention contains a negative-type photosensitive material containing components A and B, component A itself undergoes decomposition or dissolution due to the heat and the like, and a fiber cannot be formed.

The heating method of the spun fiber is not particularly limited as long as heating at the above-mentioned heating temperature is possible, and a method known per se or a method analogous thereto can be appropriately used for heating. Specific examples of the heating method include a method using a hot plate, oven and the like under atmosphere, and the like.

While the heating time of the spun fiber can be appropriately determined according to the heating temperature and the like, it is preferably 1 min - 48 hr, more preferably 5 min - 36 hr, particularly preferably 10 min - 24 hr from the aspects of crosslinking reaction rate, and production efficiency.

The fiber of the present invention shows photosensitivity. Therefore, it can be used for producing an etching mask material for processing a semiconductor material (e.g., substrate etc.), a medical material, a cosmetic material and the like. Particularly, a nano fiber and a micro fiber can be preferably used for producing an etching mask having fine pores, a cell culture substrate having a pattern (biomimetic substrate, for example, a substrate for coculture with blood vessel cells etc. to prevent degradation of cultured cells etc.), and the like.

### 2. Fiber pattern and substrate having fiber pattern

Since the fiber of the present invention shows photosensitivity, when a fiber layer of a fiber assembly is formed and the fiber layer is directly subjected to a lithography treatment, the fibers in the light exposed parts are solubilized and removed to form a fiber pattern including light unexposed parts remaining therein when the fiber of the present invention is a positive-type photosensitive fiber. On the other hand, when the fiber of the present invention is a negative-type photosensitive fiber, light unexposed parts are removed, and a fiber pattern, in which the fibers in the light exposed parts are insolubilized by crosslinking and remain, can be formed. An intricate, fine fiber pattern can be formed by applying a lithography treatment to a fiber layer of nano fibers and/or micro fibers.

The fibers in the fiber layer are one-dimensionally, two-dimensionally or three-dimensionally assembled, and the assembly state may or may not show regularity. The "pattern" in the present invention refers to something recognized as a spatial shape of an object such as design, markings and the like, which mainly consists of straight lines, curves and combination of these. The pattern may have any shape, and the pattern itself may or may not show regularity.

The present invention provides a method of forming a fiber pattern, comprising the first step for forming a fiber layer of photosensitive fibers (preferably, the fiber of the present invention) on a substrate, the second step for exposing the fiber layer to light via a mask, and the third step for developing the fiber layer with a developing solution. The method can also be said a production method of a fiber pattern. According to this method, moreover, since a substrate with a fiber pattern can be produced, the method can also be said a production method of a substrate with a fiber pattern.

### [First step]

The first step is a step for forming a fiber layer of photosensitive fibers (preferably, the fiber of the present invention) on a substrate.

A method for forming a fiber layer of photosensitive fibers (preferably, the fiber of the present invention) on a substrate is not particularly limited and, for example, a fiber layer may be formed by directly spinning the composition of the present invention on a substrate.

The substrate is not particularly limited as long as it is made from a material that does not cause deformation, denaturation and the like during a lithography treatment and, for example, film, sheet, plate, fabric (woven fabric, knitted fabric, non-woven fabric), thread and the like made of glass, ceramics, plastic, semiconductor such as silicon and the like, or the like can be used.

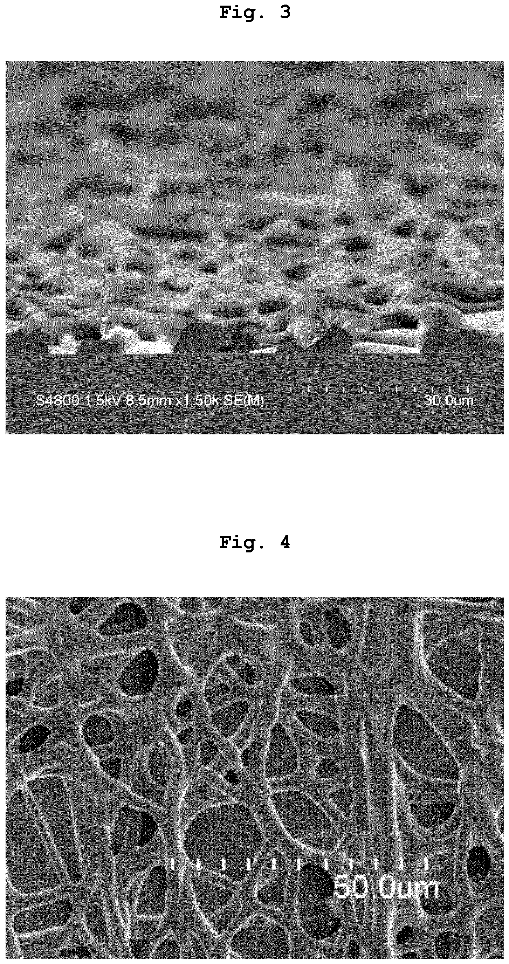

While the fabric weight after formation of a fiber pattern in a fiber layer (amount per unit area of substrate) is not particularly limited, for example, it may be an amount forming a fiber layer having a thickness of about 5 µm - 50 µm, like the fiber pattern (Fig. 3) formed in the below-mentioned Examples.

### [Second step]

The second step is a step for exposing the fiber formed on a substrate in the above-mentioned first step, to light via a mask. The light exposure can be performed, for example, using g-ray (wavelength 436 nm), h-ray (wavelength 405 nm), i-ray (wavelength 365 nm), mercury lamp, various lasers (e.g., KrF excimer laser (wavelength 248nm), ArF excimer laser (wavelength 193nm), F2 excimer laser (wavelength 157nm) and the like excimer laser etc.), LED or the like.

After exposure of photosensitive fiber to light, the fiber may be heated as necessary (Post Exposure Bake: PEB). By heating the fiber, for example, when the fiber is a negative-type photosensitive fiber, the light exposed part has a higher molecular weight than that of the light unexposed part, which is due to the action of an acid developed by exposure to light. As a result, the difference in the solubility in a developing solution between the light exposed part and the light unexposed parts becomes greater, and an effect of improved resolution contrast can be obtained. While the heating temperature can be appropriately set according to the heating time and the like, it is generally 80 - 200°C. While the heating time can be appropriately set according to the heating temperature and the like, it is generally 1 - 20 min.

### [Third step]

The third step is a step for developing the fiber exposed to light and heated as necessary in the above-mentioned second step in a developing solution. As the developing solution, a developing solution generally used for forming a pattern of a photosensitive composition can be used as appropriate. For example, when the fiber of the present invention contains a negative-type photosensitive material containing components A - C, a developing solution capable of dissolving component B, an uncrosslinked component C and the like contained in the fiber of the present invention is preferable. The developing solution used in the above-mentioned third step more preferably contains water or an organic solvent.

The water may be water alone, or various aqueous alkaline solutions (e.g., aqueous solutions of alkalis, for example, inorganic alkalis such as sodium hydroxide, potassium hydroxide, sodium carbonate, sodium silicate, metasilicate sodium, aqueous ammonia and the like; first amines such as ethylamine, N-propylamine and the like; second amines such as diethylamine, di-N-butylamine and the like; third amines such as triethylamine, methyldiethylamine and the like; alcohol amines such as dimethylethanolamine, triethanolamine and the like; quaternary ammonium salts such as tetramethylammonium hydroxide, tetraethylammonium hydroxide, choline and the like; cyclic amines such as pyrrole, piperidine and the like; and the like.

Examples of the organic solvent include alcohols (e.g., 1-butanol, 2-butanol, isobutyl alcohol, tert-butyl alcohol, 1-pentanol, 2-pentanol, 3-pentanol, 1-heptanol, 2-heptanol, tert-amyl alcohol, neopentyl alcohol, 2-methyl-1-propanol, 2-methyl-1-butanol, 2-methyl-2-butanol, 3-methyl-1-butanol, 3-methyl-3-pentanol, cyclopentanol, 1-hexanol, 2-hexanol, 3-hexanol, 2,3-dimethyl-2-butanol, 3,3-dimethyl-1-butanol, 3,3-dimethyl-2-butanol, 2-diethyl-1-butanol, 2-methyl-1-pentanol, 2-methyl-2-pentanol, 2-methyl-3-pentanol, 3-methyl-1-pentanol, 3-methyl-2-pentanol, 3-methyl-3-pentanol, 4-methyl-1-pentanol, 4-methyl-2-pentanol, 4-methyl-3-pentanol, 1-butoxy-2-propanol and cyclohexanol etc.) and solvents generally used for resist composition and the like (e.g., ethylene glycol monomethyl ether, ethylene glycol monoethyl ether, methylcellosolve acetate, ethylcellosolve acetate, diethylene glycol monomethyl ether, diethylene glycol monoethyl ether, propylene glycol, propylene glycol monomethyl ether, propylene glycol monomethyl ether acetate, propylene glycol propyl ether acetate, toluene, xylene, methylethyl ketone, cyclopentanone, cyclohexanone, ethyl 2-hydroxypropionate, ethyl 2-hydroxy-2-methylpropionate, ethyl ethoxyacetate, ethyl hydroxyacetate, methyl 2-hydroxy-3-methylbutanate, methyl 3-methoxypropionate, ethyl 3-methoxypropionate, ethyl 3-ethoxypropionate, methyl 3-ethoxypropionate, methyl pyruvate, ethyl pyruvate, ethyl acetate, butyl acetate, ethyl lactate, butyl lactate etc.) and the like.

The developing solution to be used in the third step is preferably water, ethyl lactate or an aqueous solution of tetramethylammonium hydroxide, and water or ethyl lactate is particularly preferable. The pH of the developing solution is preferably near neutral (e.g., 6 - 8) or basic (e.g., 9 - 14), and the developing solution may contain an additive such as surfactant and the like.

The fiber pattern of the present invention produced on a substrate by the above-mentioned steps is used together with the substrate or separated from the substrate and used.

When the fiber pattern of the present invention is used together with the substrate (that is, a substrate having a fiber pattern of the present invention on the surface), a substrate having a fiber pattern of the present invention formed using a nano fiber and/or a micro fiber can be preferably used as an etching mask used for processing a substrate such as semiconductor and the like, a cell culture scaffold material, and the like. When a substrate having a fiber pattern of the present invention on the surface is used as a cell culture scaffold material, the substrate is preferably made of glass or plastic.

When the fiber pattern of the present invention is a fiber pattern formed by a fiber containing a negative-type photosensitive material containing components A and B and component A is entirely or partly component A2 (preferably, biopolymer etc.), the substrate having the fiber pattern on the surface can be preferably used as a wound covering material, a face mask (for cosmetic, hygienic management) and the like.

According to the present invention, a cell culture scaffold material containing the fiber or fiber pattern of the present invention (preferably, a fiber containing a negative-type photosensitive material containing components A and B and component A is component A1, or a fiber pattern formed by the fiber; a fiber containing a negative-type photosensitive material containing components A and B and component A is entirely or partly component A2 (more preferably, biopolymer), or a fiber pattern formed by the fiber) is also provided.

### [Examples]

While specific examples of the present invention are explained below, the present invention is not limited in any way by the examples.

### [Measurement of weight average molecular weight]

In the Examples, the weight average molecular weight of polymer is measured by gel permeation chromatography (GPC). The apparatus used for the measurement and measurement conditions are as follows.
apparatus: TOSOH HLC-8320GPC system
column: Shodex (registered trade mark) KF-803 L, KF-802 and KF-801
column temperature: 40°C
eluent: DMF
flow rate: 0.6 ml/min
detector: RI
standard sample: polystyrene

### [Production method of fiber by electrospinning method]

In the Examples, fibers were produced by an electrospinning method by using Esprayer ES-2000 (manufactured by Fuence Co., Ltd.). The composition for producing a fiber was filled in a 1 ml lock-type glass syringe (manufactured by AS ONE Corporation), and a lock-type metallic needle 24G with needle length of 13 mm (manufactured by Musashi engineering) was attached. The distance from the needle tip to the substrate for receiving the fiber (discharge distance) was set to 20 cm. The applied voltage was 25 kV, and the discharge speed was 10 µl/min.

### <Synthesis of polymer 1>

N-isopropylacrylamide (20.0 g, 0.177 mol), 2-hydroxyethyl acrylate (5.13 g, 0.044 mol) and 2,2'-azobisisobutyronitrile (manufactured by Wako Pure Chemical Industries, Ltd.) (0.25 g) were dissolved in propylene glycol monomethyl ether (25.1 g) and reacted under a nitrogen atmosphere at 80°C for 24 hr to give a solution containing polymer 1. Assuming the reaction proceeded as charged, the content ratio of the structural unit derived from N-isopropylacrylamide to the whole structural unit of polymer 1 is 80 mol%, and the content ratio of the structural unit derived from 2-hydroxyethyl acrylate is 20 mol%. The weight average molecular weight of polymer 1 based on polystyrene was 19,000.

### <Preparation of polymer 2>

As polymer 2, a novolac resin contained in a thick film positive-type resist (product name: PMER (solid content concentration 40%)) manufactured by TOKYO OHKA KOGYO Co., Ltd. was used as it was.

The weight average molecular weight of polymer 2 based on polystyrene was 15,000.

### <Preparation of composition for producing photosensitive fiber>

### (Example 1)

To a solution (2 g) containing polymer 1 were added α-(methylsulfonyloxyimino)-4-methoxybenzyl cyanide (trade name: PAI-1001, manufactured by Midori Kagaku Co., Ltd.) (0.05 g), 1,3,4,6-tetrakis(methoxymethyl)glycoluril (0.015 g) and propylene glycol monomethyl ether (0.597 g) to prepare a composition for producing a negative-type photosensitive fiber of Example 1. The content ratio of polymer 1 in the composition for producing a negative-type photosensitive fiber is about 40 wt%.

### (Comparative Example 1)

In the same manner as in Example 1 except that α-(methylsulfonyloxyimino)-4-methoxybenzyl cyanide was not added, a composition for producing a negative-type photosensitive fiber of Comparative Example 1 was prepared.

### (Example 2)

Polymer 2 (8 g) and 1,2-naphthoquinonediazo-5-sulfonic acid ester (2 g) were dissolved in propylene glycol monomethyl ether acetate (15 g), and a composition for producing a positive-type photosensitive fiber of Example 2 was prepared. The concentration of the solid content (components other than solvent) in the composition for producing a positive-type photosensitive fiber of Example 2 was 40 wt%.

### <Patterning test (1)>

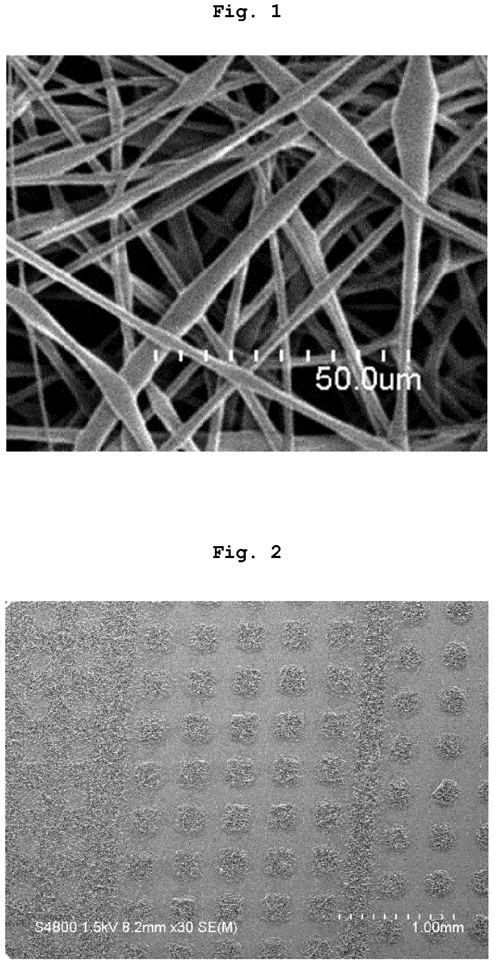

The composition for producing a negative-type photosensitive fiber of Example 1 was spun on a silicon wafer by an electrospinning method into fibers (fiber diameter of about 1 - 5 µm) to form a fiber layer. The fiber layer was photographed by a scanning electron microscope (SEM) (S-4800, manufactured by Hitachi High-Technologies Corporation) and the photograph is shown in Fig. 1. Then, the fiber layer was exposed to light via a mask by using an i-ray aligner PLA-501 (manufactured by Canon Inc., light exposure amount: 1000 mJ/cm²). After exposure to light, the fiber layer was heated (PEB) on a hot plate at 140°C for 5 min, and exposed to water for 10 min. Thereafter, the fiber layer was dried by heating at 100°C for 1 min to give a fiber pattern of width 200 µm x length 200 µm. An SEM photograph of the fiber pattern is shown in Fig. 2. In addition, an SEM photograph of a partial section of the fiber pattern is shown in Fig. 3, and an SEM photograph of a fiber part of the fiber pattern (partly enlarged fiber part of Fig. 3) is shown in Fig. 4.

Using the composition for producing a negative-type photosensitive fiber of Comparative Example 1, a patterning test was performed in the same manner as in Example 1. However, when the fiber layer after light exposure was exposed to water, the fiber was dissolved in water. Thus, a fiber pattern was not obtained.

### <patterning test (2)>

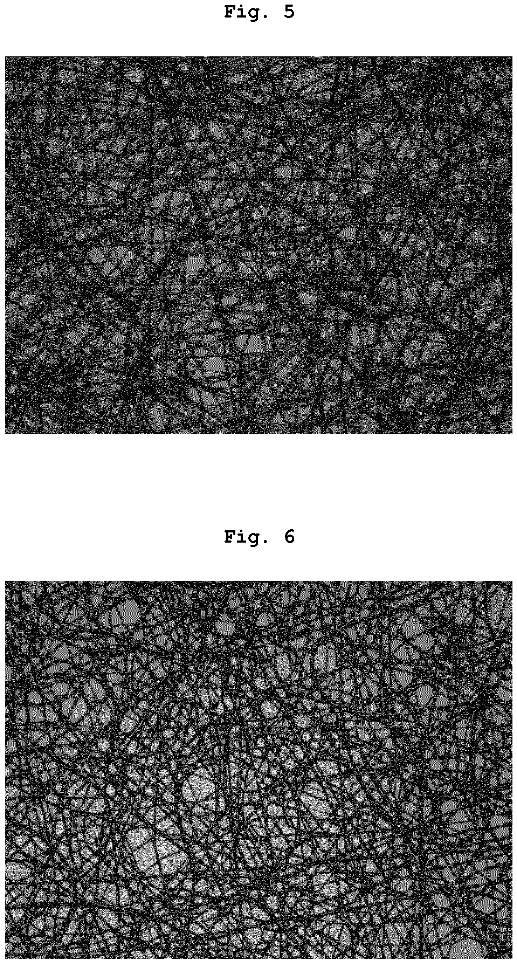

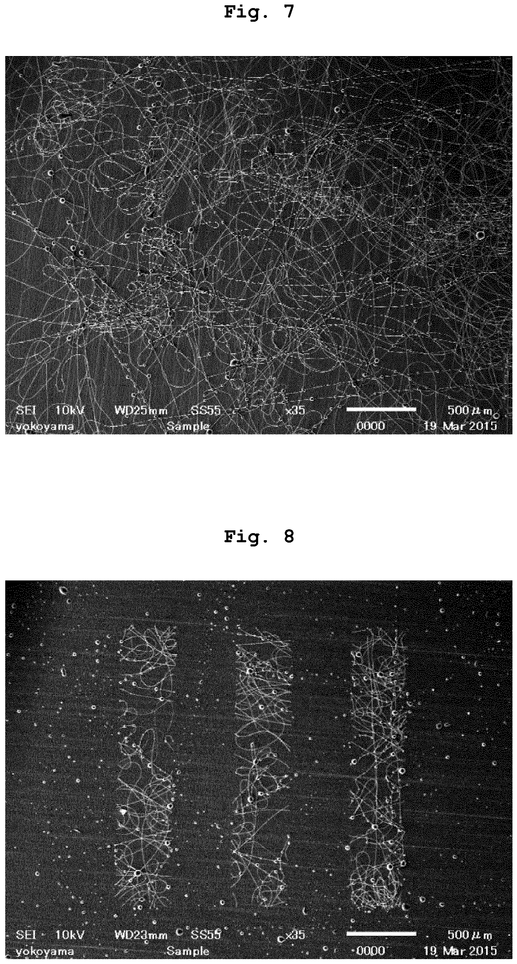

The composition for producing a positive-type photosensitive fiber of Example 2 was spun on an aluminum film (thickness 25 µm) by an electrospinning method to form a fiber layer (fiber diameter: about 1 - 5 µm). Then, the fiber layer was heated in an oven at 140°C for 2 min to remove the residual solvent in the fiber layer and thermally melt the fiber, whereby adhesion of the fiber layer and the aluminum film was improved. Optical microscopic photographs of the fiber layer before oven heating and after heating are shown in Fig. 5 and Fig. 6, respectively. The fiber layer after heating was subjected to contact light exposure via a photomask and using a super high-pressure mercury lamp as a light source. The light exposure wavelength was broadband exposure from 350 nm up to 450 nm. The amount of light exposure was measured at i-ray wavelength and set to 1000 mJ/cm². The fiber layer exposed to light was exposed to 2.38% aqueous tetramethylammonium hydroxide solution for 2 min, and then rinsed with pure water for 5 min. Thereafter, the fiber layer was dried by heating at 140°C for 5 min to give a fiber pattern of width 400 µm x length 2000 µm. An SEM photograph of the fiber layer before light exposure is shown in Fig. 7, an SEM photograph of the fiber pattern is shown in Fig. 8.

### <Temperature responsiveness of fiber>

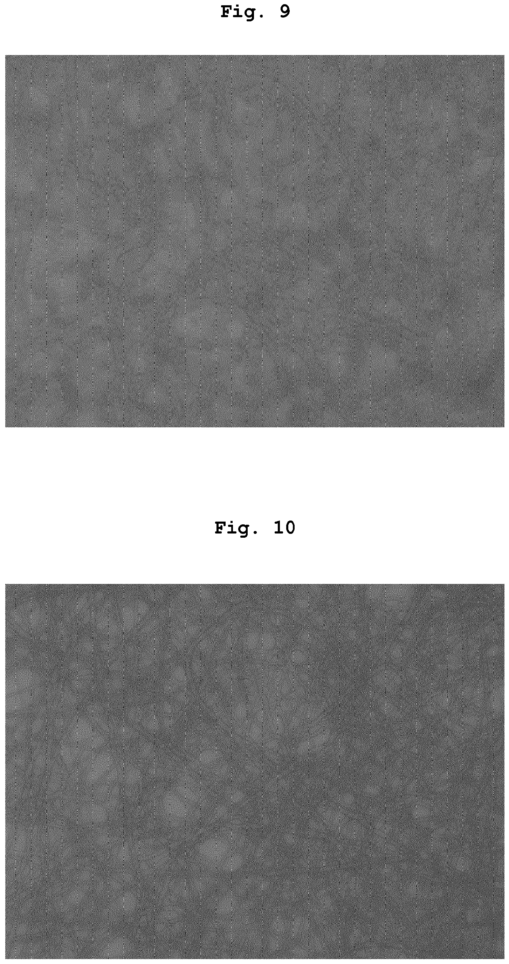

The composition for producing a negative-type photosensitive fiber of Example 1 was spun on a silicon wafer by an electrospinning method to form a fiber layer (fiber diameter: about 1 - 5 µm). Then, the fiber layer was immersed in water at 20°C and 40°C for 10 min, and the state of the fiber was observed by an optical microscope (Figs. 9 and 10). As a result of the observation, the fiber swelled at 20°C, and shrank at 40°C. Therefore, the fiber was shown to have temperature responsiveness.

### [Industrial Applicability]

According to the present invention, a photosensitive fiber capable of conveniently producing an intricate and fine resist pattern and a fiber pattern formed using the photosensitive fiber, and a production method thereof can be provided.

According to the present invention, moreover, a substrate having an intricate, fine fiber pattern on its surface can be provided.

This application is based on patent application No. 2015-087963 filed in Japan (filing date: April 22, 2015), the contents of which are encompassed in full herein.

## Claims

1. A fiber comprising a positive-type or negative-type photosensitive material.

2. The fiber according to claim 1, wherein the positive-type photosensitive material comprises (i) a novolac resin and a dissolution inhibitor, (ii) a polyvinylphenol resin or acrylic resin, and a photoacid generator, or (iii) a polyvinylphenol resin or acrylic resin comprising a structural unit having a photoacid generating group in a side chain.

3. The fiber according to claim 1 or 2, wherein the negative-type photosensitive material comprises (A) a polymer compound comprising a structural unit having, in a side chain, at least one kind of organic group selected from a hydroxy group, a hydroxymethyl group and an alkoxymethyl group having 1 - 5 carbon atoms, and (B) a photoacid generator.

4. The fiber according to any one of claims 1 to 3, which is a photosensitive fiber.

5. The fiber according to any one of claims 1 to 4, comprising a nano fiber and/or a micro fiber.

6. A composition for producing a photosensitive fiber, comprising a positive-type or negative-type photosensitive material, and a solvent.

7. The composition according to claim 6, wherein the positive-type photosensitive material comprises (i) a novolac resin and a dissolution inhibitor, (ii) a polyvinylphenol resin or acrylic resin, and a photoacid generator, or (iii) a polyvinylphenol resin or acrylic resin comprising a structural unit having a photoacid generating group in a side chain.

8. The composition according to claim 6 or 7, wherein the negative-type photosensitive material comprises (A) a polymer compound comprising a structural unit having, in a side chain, at least one kind of organic group selected from a hydroxy group, a hydroxymethyl group and an alkoxymethyl group having 1 - 5 carbon atoms, and (B) a photoacid generator.

9. A production method of a photosensitive fiber, comprising a step of spinning the composition according to any one of claims 6 to 8.

10. The method according to claim 9, wherein the above-mentioned spinning is electrospinning.

11. The method according to claim 9 or 10, comprising a step of heating a spun fiber at 70 - 300°C.

12. A method of forming a fiber pattern, comprising
the first step for forming a fiber layer of photosensitive fibers on a substrate,
the second step for exposing the fiber layer to light via a mask, and
the third step for developing the fiber layer with a developing solution.

13. The method according to claim 12, wherein the above-mentioned photosensitive fiber is the fiber according to any one of claims 1 to 5.

14. The method according to claim 12 or 13, wherein the second step comprises heating the fiber after light exposure.

15. The method according to any one of claims 12 to 14, wherein the above-mentioned developer solution comprises water or an organic solvent.

16. A fiber pattern formed using the fiber according to any one of claims 1 to 5.

17. A substrate having the fiber pattern according to claim 16 on a surface.

18. A method of producing a fiber pattern, comprising
the first step for forming a fiber layer of photosensitive fibers on a substrate,
the second step for exposing the fiber layer to light via a mask, and
the third step for developing the fiber layer with a developing solution.

19. A method of producing a substrate with a fiber pattern, comprising
the first step for forming a fiber layer of photosensitive fibers on a substrate,
the second step for exposing the fiber layer to light via a mask, and
the third step for developing the fiber layer with a developing solution.
